# FASCICULE DE BREVET EUROPEEN

(11) **EP 3 552 034 B1**
(45) Date de publication et mention de la délivrance du brevet: **22.03.2023**
(21) Numéro de dépôt: 17822373.1
(22) Date de dépôt: 05.12.2017
(51) Int. Cl.: G01R 31/327, H01H 69/01, H02H 3/00

(54) **PROCEDE DE FABRICATION D'UN CAPTEUR DE MESURE POUR UN DISJONCTEUR**
VERFAHREN ZUR HERSTELLUNG EINES MESSSENSORS FÜR EINEN LEISTUNGSSCHALTER
METHOD FOR MANUFACTURING A MEASUREMENT SENSOR FOR A CIRCUIT BREAKER

(30) Priorité: 07.12.2016 FR 1662077
(43) Date de publication de la demande: 16.10.2019
(73) Titulaire: HAGER-ELECTRO SAS, 67210 Obernai (FR)
(72) Inventeur: GACEUS, Vincent, 67210 Obernai (FR)
(74) Mandataire: Cabinet Nuss
(86) Numéro de dépôt international: PCT/FR2017/053399
(87) Numéro de publication internationale: WO 2018/104652

(56) Documents cités:
- WO-A1-2013/156153
- US-A1- 2011 050 154
- DJOKIC B: "Calibration of Rogowski Coils at Frequencies up to 10 kHz Using Digital Sampling", IEEE TRANSACTIONS ON INSTRUMENTATION AND MEASUREMENT, IEEE SERVICE CENTER, PISCATAWAY, NJ, US, vol. 59, no. 5, 1 mai 2010 (2010-05-01), pages 1303-1308, XP011306764, ISSN: 0018-9456

## Description

L'invention relève du domaine des disjoncteurs et concerne un procédé de fabrication d'un disjoncteur comprenant la fabrication d'un capteur de mesure pour ledit disjoncteur, un disjoncteur comprenant un tel capteur de mesure, ainsi qu'un procédé de commande d'un tel disjoncteur.

Les disjoncteurs de l'art antérieur comprennent en général un ou plusieurs capteur(s) de courant permettant de fournir un signal représentatif d'un courant et/ou d'une tension véhiculant dans un conducteur primaire et de fournir ce signal à une électronique d'un actionneur dudit disjoncteur. Afin d'assurer un déclenchement précis de l'actionneur, ladite électronique est calibrée en fonction de ce signal lors de l'assemblage du disjoncteur.

Ces disjoncteurs connus de l'art antérieur présentent l'inconvénient de devoir regrouper sur une même ligne de production l'assemblage du disjoncteur et le calibrage de l'ensemble des capteurs avec l'électronique du disjoncteur.

Parmi les publications de l'art antérieur, on peut citer la revue technique en ligne IEEE TRANSACTIONS ON INSTRUMENTATION AND MEASUREMENT vol. 59, no. 5, mai 2010, pages 1303-1308, XP011306764, qui a pour objet un système de calibration de bobine Rogowski jusqu'à des fréquences de 10kHz et le document US 2011/050154 qui a pour objet un appareil de commutation électrique qui comprend une pluralité de pôles comprenant un conducteur et une bobine Rogowski, un circuit processeur comprenant un circuit capteur et une mémoire qui contient, pour chacun des pôles, une valeur de décalage et un facteur de correction de gain pour le circuit de capteur. Le processeur coopère avec le circuit capteur et le nombre de routines pour fournir à chacun des pôles une valeur corrigée du courant traversant le conducteur de l'un des pôles correspondant.

La présente invention a pour but de proposer un procédé de fabrication d'un disjoncteur comprenant la fabrication d'un capteur de mesure pour ledit disjoncteur facilitant le calibrage du disjoncteur lors de son assemblage.

A cet effet, l'invention propose un procédé de fabrication d'un disjoncteur, de préférence un disjoncteur électronique, comprenant la fabrication d'un capteur de mesure pour ledit disjoncteur, ledit procédé de fabrication du capteur de mesure comportant les étapes successives suivantes :
Une étape de mise à disposition d'une unité de mesure de courant comprenant un tore apte à être traversé par un conducteur primaire et comprenant un premier conducteur enroulé autour du tore, d'un transformateur de courant apte à être traversé par le conducteur primaire, d'une unité de mesure de tension apte à être reliée au conducteur primaire pour mesurer un potentiel apparaissant dans le conducteur primaire, et d'une unité de gestion de données comprenant une mémoire non-volatile ;
Une étape de caractérisation du capteur de mesure consistant à déterminer le déphasage d'un signal électrique induit dans le premier conducteur par rapport à un signal électrique induit dans le conducteur primaire et d'un signal électrique induit dans l'unité de mesure de tension par rapport à un signal électrique induit dans le conducteur primaire, à déterminer un gain de courant du signal électrique induit dans le premier
   conducteur par rapport au signal électrique induit dans le conducteur primaire et à déterminer un gain de tension du signal électrique induit dans l'unité de mesure de tension par rapport au signal électrique induit dans le conducteur primaire ;
Une étape de paramétrage de l'unité de gestion de données consistant à enregistrer une donnée représentative du déphasage, une donnée représentative du gain de courant et une donnée représentative du gain de tension déterminés dans l'étape de caractérisation du capteur de mesure dans la mémoire non-volatile,

Procédé de fabrication d'un disjoncteur se caractérisant en ce qu'il comprend en outre les étapes successives suivantes :
Une étape de mise à disposition de l'actionneur comprenant l'unité de commande ;
Une étape d'appairage de l'unité de gestion de données à l'unité de commande consistant à relier électriquement l'unité de gestion de données à l'unité de commande de sorte à ce que l'unité de commande soit apte à prélever la donnée représentative du déphasage et/ou la donnée représentative du gain de courant et/ou la donnée représentative du gain de tension de la mémoire non-volatile de l'unité de gestion de données.

Ledit procédé de fabrication présente l'avantage de permettre le calibrage et/ou l'appairage du capteur avec une unité de commande d'un actionneur du disjoncteur de façon simple et de préférence automatique.

Selon une possibilité le procédé de fabrication est caractérisé en ce que, dans l'étape de caractérisation du capteur de mesure, le déphasage est déterminé en passant le conducteur primaire au travers du tore, en appliquant un courant alternatif à déphasage connu audit conducteur primaire, en mesurant le déphasage total du courant induit dans le premier conducteur et en soustrayant le déphasage connu du déphasage total mesuré.

Ces caractéristiques présentent l'avantage de faciliter le calibrage du déclencheur avec le ou les différent(s) capteur(s) qui lui sont associés.

Selon une caractéristique additionnelle possible, le procédé de fabrication est caractérisé en ce que, dans l'étape de caractérisation du capteur de mesure, le gain de courant est déterminé en appliquant un courant d'intensité connue au conducteur primaire, en mesurant l'intensité du courant induit dans le conducteur primaire et en divisant l'intensité du courant induit dans le conducteur primaire par l'intensité du courant d'intensité connue, et en ce que, dans l'étape de caractérisation du capteur de mesure, le gain de tension est déterminé en appliquant une tension connue au conducteur primaire, en mesurant la tension induite dans l'unité de mesure de tension et en divisant la tension induite dans l'unité de mesure de tension par la tension du courant à tension connue.

Ces caractéristiques présentent l'avantage de faciliter le calibrage du déclencheur et des différents capteurs.

Ces caractéristiques permettent un calibrage automatique du capteur de mesure et de l'unité de commande de l'actionneur de façon automatique lors de l'assemblage du disjoncteur.

L'invention a également pour objet un capteur de mesure pour un disjoncteur comportant au moins une unité de mesure de courant comprenant un tore apte à être traversé par un conducteur primaire, et un premier conducteur enroulé autour du tore, un transformateur de courant apte à être traversé par le conducteur primaire et une unité de gestion de données comprenant une mémoire non volatile. Le capteur de mesure est caractérisé en ce que le capteur de mesure comprend une unité de mesure de tension apte à être reliée au conducteur primaire pour mesurer un potentiel apparaissant dans le conducteur primaire et en ce que l'unité de mesure est fabriquée à l'aide du procédé selon l'invention.

Selon une possibilité, le tore et le premier conducteur enroulé autour du tore constituent un tore de Rogowski.

L'invention a également pour objet un disjoncteur comprenant un capteur de mesure comportant au moins une unité de mesure de courant comprenant un tore apte à être traversé par un conducteur primaire, et un premier conducteur enroulé autour du tore, un transformateur de courant apte à être traversé par le conducteur primaire et une unité de mesure de tension apte à être reliée au conducteur primaire pour mesurer un potentiel apparaissant dans le conducteur primaire, ledit disjoncteur comprenant en outre un actionneur comportant une unité de commande et se caractérisant en ce que ledit capteur de mesure comprend en outre une unité de gestion de données comprenant une mémoire non volatile, en ce que l'unité de gestion de données est reliée électriquement à l'unité de commande de sorte à ce que l'unité de commande soit apte à prélever la donnée représentative du déphasage et/ou la donnée représentative du gain de courant et/ou la donnée représentative du gain de tension de la mémoire non volatile de l'unité de gestion de données et en ce que l'unité de mesure est fabriquée à l'aide du procédé selon l'invention.

Selon une possibilité, l'unité de commande comprend au moins un microcontrôleur et au moins une mémoire, de préférence non volatile, le microcontrôleur étant de préférence apte à sauvegarder la donnée représentative du déphasage et/ou la donnée représentative du gain de courant et/ou la donnée représentative du gain de tension dans la mémoire de l'unité de commande. Ainsi, une sauvegarde de l'appairage entre le capteur de mesure et le déclencheur peut être effectuée.

L'invention a également pour objet un procédé de commande du disjoncteur selon l'invention. Le procédé de commande est caractérisé en ce qu'il comprend les étapes successives suivantes :
Une étape de prélèvement de la donnée représentative du déphasage et/ou la donnée représentative du gain de courant et/ou la donnée représentative du gain de tension depuis la mémoire non-volatile de l'unité de gestion de données par le microcontrôleur de l'unité de commande ;
Une étape de sauvegarde de la donnée représentative du déphasage et/ou la donnée représentative du gain de courant et/ou la donnée représentative du gain de tension dans la mémoire de l'unité de commande ;
Une étape calibrage de l'unité de commande consistant à déterminer au moins un seuil de déclenchement en fonction de la donnée représentative du déphasage et/ou la donnée représentative du gain de courant et/ou la donnée représentative du gain de tension et/ou en fonction d'un réglage de l'utilisateur ; et

Une étape de fonctionnement dans laquelle l'actionneur est déclenché lorsque le courant mesuré par l'unité de mesure de courant est supérieur au seuil de déclenchement.

Selon une caractéristique additionnelle possible, dans l'étape de fonctionnement, l'unité de commande vérifie à intervalles de temps réguliers et de façon permanente que l'unité de commande est reliée électriquement à l'unité de gestion de données et, au cas où le lien entre l'unité de commande et l'unité de gestion de données est interrompu, à passer dans un mode de fonctionnement de secours.

Ces caractéristiques permettent d'assurer la continuité du fonctionnement correct et précis du disjoncteur.

Selon une possibilité, dans le mode de fonctionnement de secours, l'actionneur est déclenché.

Ainsi, le disjoncteur se déclenche, dès qu'une interruption du lien entre l'unité de commande et l'unité de gestion de données est détectée.

Selon une caractéristique additionnelle possible, dans le mode de fonctionnement de secours, un utilisateur est averti de l'interruption du lien entre l'unité de commande et l'unité de gestion de données à l'aide d'un voyant, de préférence agencé sur l'unité de commande.

Ainsi, l'utilisateur est informé d'un potentiel manque de service dans le déclenchement du déclencheur suite à une interruption du lien entre l'unité de commande et l'unité de gestion de données.

Selon une caractéristique additionnelle possible, dans le mode de fonctionnement de secours, un message comprenant une information représentative de l'état du lien entre l'unité de commande et l'unité de gestion de données est émis à l'aide d'un émetteur de l'unité de commande, de préférence à destination d'un dispositif de visualisation déporté ou non de l'unité de commande.

Ainsi, l'utilisateur peut être informé d'un éventuel mauvais fonctionnement du disjoncteur, par exemple à l'aide d'un dispositif de visualisation, qui peut être agencé sur le disjoncteur et/ou l'unité de commande ou déporté de ceux-ci.

L'invention sera mieux comprise, grâce à la description ci-après, qui se rapporte à un mode de réalisation préféré, donné à titre d'exemple non limitatif, et expliqué avec référence aux dessins schématiques annexés, dans lesquels :
La figure 1 représente schématiquement un disjoncteur selon le mode de réalisation comprenant quatre capteurs de mesure selon le mode de réalisation et un actionneur ;
La figure 2 représente un schéma du capteur de mesure selon le mode de réalisation.

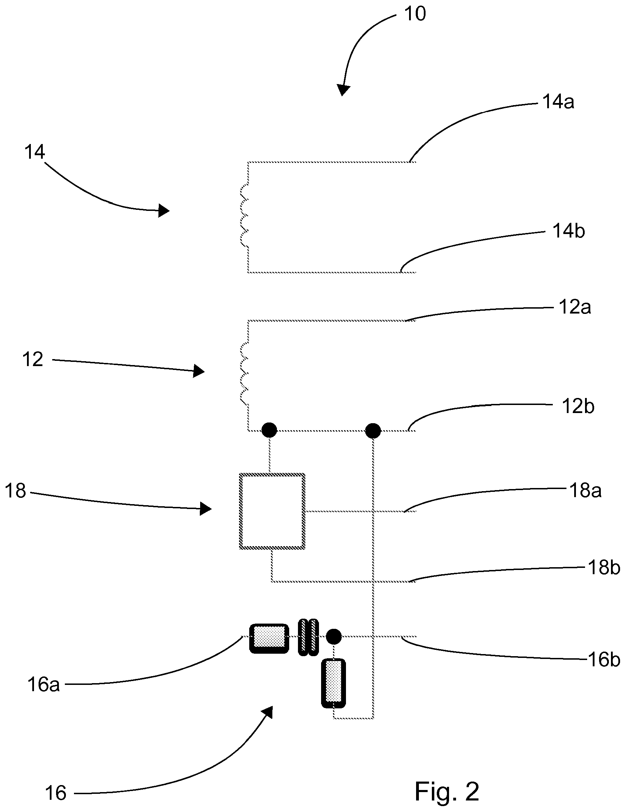

La figure 2 divulgue un capteur 10 de mesure pour un disjoncteur 100 selon le mode de réalisation. Le disjoncteur 100 est de préférence un disjoncteur électronique. Ledit disjoncteur 100 comporte au moins un capteur de mesure 10 comprenant une unité de mesure de courant 12 comportant un tore apte à être traversé par un conducteur primaire R, S, T, N et un premier conducteur enroulé autour du tore. Le capteur de mesure 10 comprend en outre un transformateur de courant 14 apte lui aussi à être traversé par le conducteur primaire R, S, T, N et une unité de gestion de données 18 comprenant une mémoire non volatile.

Le capteur de mesure 10 comprend une unité de mesure de tension 16 apte à être reliée au conducteur primaire R, S, T, N pour mesurer un potentiel apparaissant dans le conducteur R, S, T, N.

Le capteur de courant 10 selon le mode de réalisation est fabriqué à l'aide d'un procédé de fabrication du capteur de mesure 10 pour le disjoncteur 100 comportant les étapes successives suivantes :
Une étape de mise à disposition d'une unité de mesure de courant 12 comprenant un tore apte à être traversé par un conducteur primaire R, S, T, N et comprenant un premier conducteur enroulé autour du tore, d'un transformateur de courant 14 apte à être traversé par le conducteur primaire R, S, T, N, d'une unité de mesure de tension 16 apte à être reliée au conducteur primaire R, S, T, N pour mesurer un potentiel apparaissant dans le conducteur primaire R, S, T, N, et d'une unité de gestion de données 18 comprenant une mémoire non-volatile 20 ;
Une étape de caractérisation du capteur de mesure 10 consistant à déterminer le déphasage d'un signal électrique induit dans le premier conducteur par rapport à un signal électrique induit dans le conducteur primaire R, S, T, N et d'un signal électrique induit dans l'unité de mesure de tension 16 par rapport à un signal électrique induit dans le conducteur primaire R, S, T, N, à déterminer un gain de courant du signal électrique induit dans le premier conducteur par rapport au signal électrique induit dans le conducteur primaire R, S, T, N et à déterminer un gain de tension du signal électrique induit dans l'unité de mesure de tension 16 par rapport au signal électrique induit dans le conducteur primaire R, S, T, N ;
Une étape de paramétrage de l'unité de gestion de données 18 consistant à enregistrer une donnée représentative du déphasage, une donnée représentative du gain de courant et une donnée représentative du gain de tension déterminés dans l'étape de caractérisation du capteur de mesure 10 dans la mémoire non-volatile 20.

De préférence, le tore et le premier conducteur enroulé autour du tore constituent un tore de Rogowski.

Selon une possibilité du procédé de fabrication du capteur de mesure 10 pour le disjoncteur 100, dans l'étape de caractérisation du capteur de mesure, le déphasage est déterminé en passant le conducteur primaire R, S, T, N au travers du tore, en appliquant un courant alternatif à déphasage connu audit conducteur primaire R, S, T, N, en mesurant le déphasage total du courant induit dans le premier conducteur et en soustrayant le déphasage connu du déphasage total mesuré.

Selon une caractéristique additionnelle du procédé de fabrication du capteur de mesure 10 pour le disjoncteur 100 selon le mode de réalisation, dans l'étape de caractérisation du capteur de mesure 10, le gain de courant est déterminé en appliquant un courant d'intensité connue au conducteur primaire R, S, T, N, en mesurant l'intensité du courant induit dans le conducteur primaire R, S, T, N et en divisant l'intensité du courant induit dans le conducteur primaire R, S, T, N par l'intensité du courant d'intensité connue Dans l'étape de caractérisation du capteur de mesure, le gain de tension est déterminé en appliquant une tension connue au conducteur primaire R, S, T, N, en mesurant la tension induite dans l'unité de mesure de tension 16 et en divisant la tension induite dans l'unité de mesure de tension 16 par la tension connue.

Le mode de réalisation concerne en outre un procédé de fabrication du disjoncteur 100 qui comprend la fabrication du capteur de mesure 10 selon le mode de réalisation. Le procédé de fabrication du disjoncteur comprend en outre les étapes successives suivantes :
Une étape de mise à disposition d'un actionneur 60 comprenant une unité de commande 62 ;
Une étape d'appairage de l'unité de gestion de données 18 à l'unité de commande 62 consistant à relier électriquement l'unité de gestion de données 18 à l'unité de commande 62 de sorte à ce que l'unité de commande 62 soit apte à prélever la donnée représentative du déphasage et/ou la donnée représentative du gain de courant et/ou la donnée représentative du gain de tension de la mémoire non-volatile 20 de l'unité de gestion de données 18.

Le disjoncteur 100, de préférence un disjoncteur électronique, comprend au moins un capteur de mesure 10 selon le mode de réalisation.

De préférence, le disjoncteur 100 comprend un capteur de mesure par phase à protéger. Le disjoncteur 100 comprend en outre un actionneur 60 comportant une unité de commande 62. L'unité de gestion de données 18 du capteur de mesure 10 est reliée électriquement à l'unité de commande 62 de sorte à ce que l'unité de commande 62 soit apte à prélever la donnée représentative du déphasage et/ou la donnée représentative du gain de courant et/ou la donnée représentative du gain de tension de la mémoire non volatile 20 de l'unité de gestion de données 18.

Selon une possibilité, l'unité de commande 62 comprend au moins un microcontrôleur 66 et au moins une mémoire 64, de préférence non volatile. Le microcontrôleur 66 est de préférence apte à sauvegarder la donnée représentative du déphasage et/ou la donnée représentative du gain de courant et/ou la donnée représentative du gain de tension dans la mémoire 64 de l'unité de commande 62.

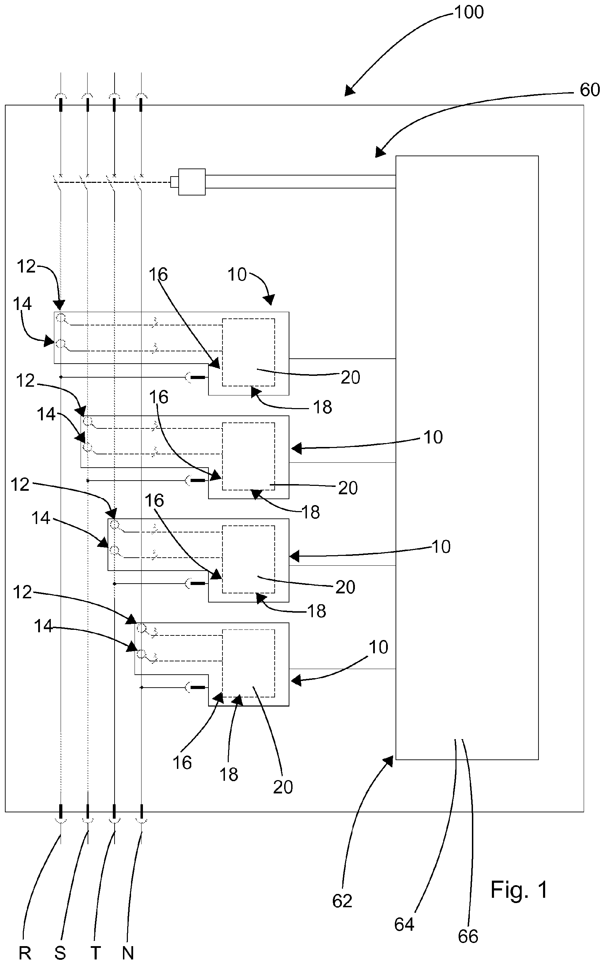

Comme le divulgue en particulier la figure 1, le disjoncteur 100 selon le mode de réalisation comprend un actionneur 60 comportant une unité de commande 62, ainsi que quatre capteurs de mesure 10 selon le mode de réalisation. L'unité de mesure de courant 12 et le transformateur de courant 14 de chaque capteur de mesure 10 du disjoncteur 100 sont respectivement traversés par l'un des quatre conducteurs primaires R, S, T, N. L'unité de gestion de données 18 de chaque capteur de mesure 10 est de préférence reliée électriquement à l'unité de commande 62 de l'actionneur 60 de sorte à ce que l'unité de commande 62 soit apte à prélever, de chaque capteur de mesure, la donnée représentative du déphasage et/ou la donnée représentative du gain de courant et/ou les données représentatives du gain de tension de la mémoire non volatile 20 de l'unité de gestion de données 18. A l'aide du procédé de fabrication du capteur de mesure 10 selon le mode de réalisation, chaque capteur de mesure 10 peut alors comprendre dans sa mémoire non volatile 20 une donnée représentative de son déphasage, une donnée représentative de son gain de courant et une donnée représentative de son gain de tension respectif. Chaque capteur de mesure 10 peut être apte pour permettre le prélèvement de ces données depuis l'unité de commande 62 de l'actionneur.

Comme il ressort en particulier de la figure 2, le transformateur de courant 14 de chaque capteur de mesure 10 comprend de préférence un pôle positif 14a et un pôle négatif 14b. L'unité de mesure de courant 12 de chaque capteur de mesure 10 comprend de préférence un pôle positif 12a et une terre 12b, également nommée masse analogique (AGND). La terre 12b peut être, d'une part, reliée à l'unité de gestion de données 18 et d'autre part à l'unité de mesure de tension 16. L'unité de gestion de données 18 comprend, d'une part, une interface de communication 18a et, d'autre part, une alimentation 18b (VCC).

L'unité de mesure de tension 16 peut comprendre un premier pôle 16a et un deuxième pôle 16b. Une première tension peut être appliquée au premier pôle 16a et à la terre 12b, ou masse analogique. Une deuxième tension, induite de la première tension, issue du deuxième pôle 16b, peut être appliquée à l'unité de gestion de données 18. L'unité de mesure de tension 16 peut comprendre deux séries de résistances entre lesquelles est relié en série un condensateur.

Le mode de réalisation concerne également un procédé de commande du disjoncteur 100 selon le mode de réalisation. Le procédé de commande du disjoncteur 100 comprend les étapes successives suivantes :
Une étape de prélèvement de la donnée représentative du déphasage et/ou la donnée représentative du gain de courant et/ou la donnée représentative du gain de tension depuis la mémoire non-volatile 20 de l'unité de gestion de données 18 par le microcontrôleur 66 de l'unité de commande 62 ;
Une étape de sauvegarde de la donnée représentative du déphasage et/ou la donnée représentative du gain de courant et/ou la donnée représentative du gain de tension dans la mémoire 64 de l'unité de commande 62 ;
Une étape calibrage de l'unité de commande 62 consistant à déterminer au moins un seuil de déclenchement en fonction de la donnée représentative du déphasage et/ou la donnée représentative du gain de courant et/ou la donnée représentative du gain de tension et/ou en fonction d'un réglage de protection de l'utilisateur ; et
Une étape de fonctionnement dans laquelle l'actionneur 60 est déclenché lorsque le courant mesuré par l'unité de mesure de courant 12 est supérieur au seuil de déclenchement.

Selon une possibilité du procédé de commande, dans l'étape de fonctionnement, l'unité de commande 62 peut vérifier à intervalles de temps réguliers et de façon permanente que l'unité de commande 62 est reliée électriquement à l'unité de gestion de données 18 et, au cas où le lien entre l'unité de commande 62 et l'unité de gestion de données 18 est interrompu, à passer dans un mode de fonctionnement de secours.

Lorsqu'une rupture du lien entre l'unité de commande 62 et l'unité de gestion de données 18 intervient, le procédé de commande passe dans un mode de fonctionnement de secours, dans lequel, soit l'actionneur 60 est déclenché pour ouvrir un circuit électrique auquel est associé le disjoncteur pour le protéger, soit l'utilisateur est averti de l'interruption du lien entre l'unité de commande 62 et l'unité de gestion de données 18, de préférence à l'aide d'un voyant. Le voyant est de préférence agencé sur l'unité de commande 62 et/ou sur le disjoncteur 100.

Selon une autre possibilité, dans le mode de fonctionnement de secours, un message comprenant une information représentative de l'état du lien entre l'unité de commande 62 et l'unité de gestion de données 18 est émis à l'aide d'un émetteur de l'unité de commande 62, de préférence à destination d'un dispositif de visualisation déporté ou non de l'unité de commande 62 et/ou du disjoncteur 100.

Dans le mode de fonctionnement de secours, l'actionneur 60 est déclenché et le circuit électrique à protéger est ouvert, de préférence en permanence jusqu'à ce que le capteur de mesure 10 correspondant soit remplacé ou jusqu'à ce que le lien entre l'unité de commande 62 et l'unité de gestion de données 18 soit réétablie. Ce principe de fonctionnement privilégie la sécurité par rapport à la continuité de fonctionnement.

Selon une autre possibilité du procédé de commande selon le mode de réalisation, dans le mode de fonctionnement de secours, un utilisateur est averti de l'interruption du lien entre l'unité de commande 62 et l'unité de gestion de données 18. Selon cette possibilité, le disjoncteur 100 continue à fonctionner dans le mode de fonctionnement de secours sans pouvoir prélever, à l'aide de l'unité de commande 62, la donnée représentative du déphasage et/ou la donnée représentative du gain de courant et/ou la donnée représentative du gain de tension, et ainsi effectuer un calibrage de l'unité de commande 62. Même si, dans le mode de fonctionnement de secours selon cette caractéristique, le déclenchement du déclencheur 60 du disjoncteur 100 sera moins précis, la continuité de fonctionnement du disjoncteur 100 est assurée.

Selon une possibilité, un numéro de série unique peut être embarqué dans la mémoire non-volatile 20 de l'unité de gestion de données 18 et le procédé de commande comprend une étape qui consiste à, à l'aide de l'unité de commande 62, prélever à intervalles réguliers le numéro de série unique et vérifier que deux numéros de série uniques prélevés à la suite l'un de l'autre sont les mêmes. Lorsqu'un changement du numéro de série unique entre deux prélèvements de celui-ci par l'unité de commande 62 est détecté, l'étape d'appairage de l'unité de gestion de données 18 à l'unité de commande peut être réitérée.

## Revendications

1. Procédé de fabrication d'un disjoncteur (100) comprenant la fabrication d'un capteur de mesure (10) pour ledit disjoncteur (100), ledit procédé de fabrication du capteur de mesure (10) comportant les étapes successives suivantes :
Une étape de mise à disposition d'une unité de mesure de courant (12) comprenant un tore apte à être traversé par un conducteur primaire (R, S, T, N) et comprenant un premier conducteur enroulé autour du tore, d'un transformateur de courant (14) apte à être traversé par le conducteur primaire (R, S, T, N), d'une unité de mesure de tension (16) apte à être reliée au conducteur primaire (R, S, T, N) pour mesurer un potentiel apparaissant dans le conducteur primaire (R, S, T, N), et d'une unité de gestion de données (18) comprenant une mémoire non-volatile (20) ;
Une étape de caractérisation du capteur de mesure (10) consistant à déterminer le déphasage d'un signal électrique induit dans le premier conducteur par rapport à un signal électrique induit dans le conducteur primaire (R, S, T, N) et d'un signal électrique induit dans l'unité de mesure de tension (16) par rapport à un signal électrique induit dans le conducteur primaire (R, S, T, N), à déterminer un gain de courant du signal électrique induit dans le premier conducteur par rapport au signal électrique induit dans le conducteur primaire (R, S, T, N) et à déterminer un gain de tension du signal électrique induit dans l'unité de mesure de tension (16) par rapport au signal électrique induit dans le conducteur primaire (R, S, T, N) ;
Une étape de paramétrage de l'unité de gestion de données (18) consistant à enregistrer une donnée représentative du déphasage, une donnée représentative du gain de courant et une donnée représentative du gain de tension déterminés dans l'étape de caractérisation du capteur de mesure (10) dans la mémoire non-volatile (20),
procédé de fabrication d'un disjoncteur (100) **caractérisé en ce qu'**il comporte en outre les étapes successives suivantes :
Une étape de mise à disposition d'un actionneur (60) comprenant une unité de commande (62) ;
Une étape d'appairage de l'unité de gestion de données (18) à l'unité de commande (62) consistant à relier électriquement l'unité de gestion de données (18) à l'unité de commande (62) de sorte à ce que l'unité de commande (62) soit apte à prélever la donnée représentative du déphasage et/ou la donnée représentative du gain de courant et/ou la donnée représentative du gain de tension de la mémoire non-volatile (20) de l'unité de gestion de données (18).

2. Procédé de fabrication d'un disjoncteur (100) selon la revendication 1, **caractérisé en ce que**, dans l'étape de caractérisation du capteur de mesure, le déphasage est déterminé en passant le conducteur primaire (R, S, T, N) au travers du tore, en appliquant un courant alternatif à déphasage connu audit conducteur primaire (R, S, T, N), en mesurant le déphasage total du courant induit dans le premier conducteur et en soustrayant le déphasage connu du déphasage total mesuré.

3. Procédé de fabrication d'un disjoncteur (100) selon l'une quelconque des revendications 1 ou 2, **caractérisé en ce que**, dans l'étape de caractérisation du capteur de mesure, le gain de courant est déterminé en appliquant un courant d'intensité connue au conducteur primaire (R, S, T, N), en mesurant l'intensité du courant induit dans le conducteur primaire (R, S, T, N) et en divisant l'intensité du courant induit dans le conducteur primaire (R, S, T, N) par l'intensité du courant d'intensité connue, et **en ce que**, dans l'étape de caractérisation du capteur de mesure, le gain de tension est déterminé en appliquant une tension connue au conducteur primaire (R, S, T, N), en mesurant la tension induite dans l'unité de mesure de tension (16) et en divisant la tension induite dans l'unité de mesure de tension (16) par la tension du courant à tension connue.

4. Disjoncteur comprenant un capteur de mesure (10), ledit capteur de mesure (10) comportant au moins une unité de mesure de courant (12) comprenant un tore apte à être traversé par un conducteur primaire (R, S, T, N), et un premier conducteur enroulé autour du tore, un transformateur de courant (14) apte à être traversé par le conducteur primaire (R, S, T, N) et une unité de mesure de tension (16) apte à être reliée au conducteur primaire (R, S, T, N) pour mesurer un potentiel apparaissant dans le conducteur primaire (R, S, T, N), ledit disjoncteur comprenant en outre un actionneur (60) comportant une unité de commande (62) **caractérisé en ce que** ledit capteur de mesure (10) comprend en outre une unité de gestion de données (18) comprenant une mémoire non-volatile (20), **en ce que** l'unité de gestion de données (18) est reliée électriquement à l'unité de commande (62) de sorte à ce que l'unité de commande (62) soit apte à prélever la donnée représentative du déphasage et/ou la donnée représentative du gain de courant et/ou la donnée représentative du gain de tension de la mémoire non-volatile (20) de l' unité de gestion de données (18) et **en ce que** l'unité de mesure est fabriquée à l'aide du procédé selon l'une quelconque des revendications 1 à 3.

5. Disjoncteur selon la revendication 4, **caractérisé en ce que** l'unité de commande (62) comprend au moins un microcontrôleur (66) et au moins une mémoire (64), de préférence non-volatile, le microcontrôleur (66) étant de préférence apte à sauvegarder la donnée représentative du déphasage et/ou la donnée représentative du gain de courant et/ou la donnée représentative du gain de tension dans la mémoire (64) de l'unité de commande (62).

6. Disjoncteur selon la revendication 4 ou la revendication 5, **caractérisé en ce que** le tore et le premier conducteur enroulé autour du tore constituent un tore de Rogowski.

7. Procédé de commande d'un disjoncteur (100) selon l'une quelconque des revendications 4 à 6, **caractérisé en ce qu'**il comprend les étapes successives suivantes :
Une étape de prélèvement de la donnée représentative du déphasage et/ou la donnée représentative du gain de courant et/ou la donnée représentative du gain de tension depuis la mémoire non-volatile (20) de l'unité de gestion de données (18) par le microcontrôleur (66) de l'unité de commande (62) ;
Une étape de sauvegarde de la donnée représentative du déphasage et/ou la donnée représentative du gain de courant et/ou la donnée représentative du gain de tension dans la mémoire (64) de l'unité de commande (62) ;
Une étape calibrage de l'unité de commande (62) consistant à déterminer au moins un premier seuil de déclenchement en fonction de la donnée représentative du déphasage et/ou la donnée représentative du gain de courant et/ou la donnée représentative du gain de tension ; et
Une étape de fonctionnement dans laquelle l'actionneur (60) est déclenché lorsque le courant mesuré par l'unité de mesure de courant (12) est supérieur au premier seuil de déclenchement.

8. Procédé de commande selon la revendication 7, **caractérisé en ce que**, dans l'étape de fonctionnement, l'unité de commande (62) vérifie à intervalles de temps réguliers et de façon permanente que l'unité de commande (62) est reliée électriquement à l'unité de gestion de données (18) et, au cas où le lien entre l'unité de commande (62) et l'unité de gestion de données (18) est interrompu, à passer dans un mode de fonctionnement de secours.

9. Procédé de commande selon la revendication 8, **caractérisé en ce que**, dans le mode de fonctionnement de secours, l'actionneur (60) est déclenché.

10. Procédé de commande selon la revendication 8, **caractérisé en ce que**, dans le mode de fonctionnement de secours, un utilisateur est averti de l'interruption du lien entre l'unité de commande (62) et l'unité de gestion de données (18) à l'aide d'un voyant, de préférence agencé sur l'unité de commande.

11. Procédé de commande selon la revendication 8, **caractérisé en ce que**, dans le mode de fonctionnement de secours, un message comprenant une information représentative de l'état du lien entre l'unité de commande (62) et l'unité de gestion de données (18) est émis à l'aide d'un émetteur de l'unité de commande (62), de préférence à destination d'un dispositif de visualisation déporté ou non de l'actionneur (60).

## Patentansprüche

1. Verfahren zur Herstellung eines Leistungsschalters (100), das die Herstellung eines Messsensors (10) für den Leistungsschalter (100) enthält, wobei das Herstellungsverfahren des Messsensors (10) die folgenden aufeinanderfolgenden Schritte aufweist:
einen Schritt der Bereitstellung einer Strommesseinheit (12), die einen Torus enthält, der von einem Primärleiter (R, S, T, N) durchquert werden kann und einen ersten um den Torus gewickelten Leiter enthält, eines Stromwandlers (14), der vom Primärleiter (R, S, T, N) durchquert werden kann, einer Spannungsmesseinheit (16), die mit dem Primärleiter (R, S, T, N) verbunden werden kann, um ein im Primärleiter (R, S, T, N) auftretendes Potential zu messen, und einer Datenverwaltungseinheit (18), die einen nicht-flüchtigen Speicher (20) enthält;
einen Schritt der Charakterisierung des Messsensors (10), der darin besteht, die Phasenverschiebung eines in den ersten Leiter induzierten elektrischen Signals im Verhältnis zu einem in den Primärleiter (R, S, T, N) induzierten elektrischen Signal und eines in die Spannungsmesseinheit (16) induzierten elektrischen Signals im Verhältnis zu einem in den Primärleiter (R, S, T, N) induzierten elektrischen Signal zu bestimmen, eine Stromverstärkung des in den ersten Leiter induzierten elektrischen Signals im Verhältnis zum in den Primärleiter (R, S, T, N) induzierten elektrischen Signal zu bestimmen, und eine Spannungsverstärkung des in die Spannungsmesseinheit (16) induzierten elektrischen Signals im Verhältnis zum in den Primärleiter (R, S, T, N) induzierten Signal zu bestimmen;
einen Schritt der Parametrierung der Datenverwaltungseinheit (18), der darin besteht, einen für die Phasenverschiebung repräsentativen Datenwert, einen für die Stromverstärkung repräsentativen Datenwert und einen für die Spannungsverstärkung repräsentativen Datenwert, die im Schritt der Charakterisierung des Messsensors (10) bestimmt werden, im nicht-flüchtigen Speicher (20) zu speichern,
Herstellungsverfahren eines Leistungsschalters (100), **dadurch gekennzeichnet, dass** es außerdem die folgenden aufeinanderfolgenden Schritte aufweist:
einen Schritt der Bereitstellung eines eine Steuereinheit (62) enthaltenden Aktors (60);
einen Schritt der paarweisen Verbindung der Datenverwaltungseinheit (18) mit der Steuereinheit (62), der darin besteht, die Datenverwaltungseinheit (18) elektrisch mit der Steuereinheit (62) zu verbinden, damit die Steuereinheit (62) fähig ist, den für die Phasenverschiebung repräsentativen Wert und/oder den für die Stromverstärkung repräsentativen Datenwert und/oder den für die Spannungsverstärkung repräsentativen Datenwert aus dem nicht-flüchtigen Speicher (20) der Datenverwaltungseinheit (18) zu entnehmen.

2. Herstellungsverfahren eines Leistungsschalters (100) nach Anspruch 1, **dadurch gekennzeichnet, dass** im Schritt der Charakterisierung des Messsensors die Phasenverschiebung bestimmt wird, indem der Primärleiter (R, S, T, N) durch den Torus geführt wird, indem ein Wechselstrom mit bekannter Phasenverschiebung an den Primärleiter (R, S, T, N) angelegt wird, indem die gesamte Phasenverschiebung des in den ersten Leiter induzierten Stroms gemessen und die bekannte Phasenverschiebung von der gemessenen gesamten Phasenverschiebung subtrahiert wird.

3. Herstellungsverfahren eines Leistungsschalters (100) nach einem der Ansprüche 1 oder 2, **dadurch gekennzeichnet, dass** im Schritt der Charakterisierung des Messsensors die Stromverstärkung bestimmt wird durch Anlegen eines Stroms bekannter Stärke an den Primärleiter (R, S, T, N), durch Messen der Stärke des in den Primärleiter (R, S, T, N) induzierten Stroms und durch Dividieren der Stärke des in den Primärleiter (R, S, T, N) induzierten Stroms durch die Stärke des Stroms bekannter Stärke, und dass im Schritt der Charakterisierung des Messsensors die Spannungsverstärkung bestimmt wird durch Anlegen einer bekannten Spannung an den Primärleiter (R, S, T, N), durch Messen der in die Spannungsmesseinheit (16) induzierten Spannung und durch Dividieren der in die Spannungsmesseinheit (16) induzierten Spannung durch die Spannung des Stroms mit bekannter Spannung.

4. Leistungsschalter, der einen Messsensor (10) enthält, wobei der Messsensor (10) mindestens eine Strommesseinheit (12), die einen Torus, der von einem Primärleiter (R, S, T, N) durchquert werden kann, und einen ersten um den Torus gewickelten Leiter enthält, einen Stromwandler (14), der vom Primärleiter (R, S, T, N) durchquert werden kann, und eine Spannungsmesseinheit (16) aufweist, die mit dem Primärleiter (R, S, T, N) verbunden werden kann, um ein Potential zu messen, das im Primärleiter (R, S, T, N) auftritt, wobei der Leistungsschalter außerdem einen eine Steuereinheit (62) aufweisenden Aktor (60) enthält, **dadurch gekennzeichnet, dass** der Messsensor (10) außerdem eine Datenverwaltungseinheit (18) enthält, die einen nicht-flüchtigen Speicher (20) enthält, dass die Datenverwaltungseinheit (18) elektrisch mit der Steuereinheit (62) verbunden ist, damit die Steuereinheit (62) fähig ist, den für die Phasenverschiebung repräsentativen Datenwert und/oder den für die Stromverstärkung repräsentativen Datenwert und/oder den für die Spannungsverstärkung des nicht-flüchtigen Speichers (20) der Datenverwaltungseinheit (18) repräsentativen Datenwert zu entnehmen, und dass die Messeinheit mit Hilfe des Verfahrens nach einem der Ansprüche 1 bis 3 hergestellt wird.

5. Leistungsschalter nach Anspruch 4, **dadurch gekennzeichnet, dass** die Steuereinheit (62) mindestens einen Mikrocontroller (66) und mindestens einen vorzugsweise nicht-flüchtigen Speicher (64) enthält, wobei der Mikrocontroller (66) vorzugsweise fähig ist, den für die Phasenverschiebung repräsentativen Datenwert und/oder den für die Stromverstärkung repräsentativen Datenwert und/oder den für die Spannungsverstärkung repräsentativen Datenwert im Speicher (64) der Steuereinheit (62) zu sichern.

6. Leistungsschalter nach Anspruch 4 oder Anspruch 5, **dadurch gekennzeichnet, dass** der Torus und der um den Torus gewickelte erste Leiter einen Rogowski-Torus bilden.

7. Steuerverfahren eines Leistungsschalters (100) nach einem der Ansprüche 4 bis 6, **dadurch gekennzeichnet, dass** es die folgenden aufeinanderfolgenden Schritte enthält:
einen Schritt der Entnahme des für die Phasenverschiebung repräsentativen Datenwerts und/oder des für die Stromverstärkung repräsentativen Datenwerts und/oder des für die Spannungsverstärkung repräsentativen Datenwerts aus dem nicht-flüchtigen Speicher (20) der Datenverwaltungseinheit (18) durch den Mikrocontroller (66) der Steuereinheit (62);
einen Schritt des Sicherns des für die Phasenverschiebung repräsentativen Datenwerts und/oder des für die Stromverstärkung repräsentativen Datenwerts und/oder des für die Spannungsverstärkung repräsentativen Datenwerts im Speicher (64) der Steuereinheit(62);
einen Kalibrierungsschritt der Steuereinheit (62), der darin besteht, mindestens eine erste Auslöseschwelle abhängig vom für die Phasenverschiebung repräsentativen Datenwert und/oder vom für die Stromverstärkung repräsentativen Datenwert und/oder vom für die Spannungsverstärkung repräsentativen Datenwert zu bestimmen; und
einen Betriebsschritt, in dem der Aktor (60) ausgelöst wird, wenn der von der Strommesseinheit (12) gemessene Strom höher ist als die erste Auslöseschwelle.

8. Steuerverfahren nach Anspruch 7, **dadurch gekennzeichnet, dass** im Betriebsschritt die Steuereinheit (62) in gleichmäßigen Zeitabständen und permanent überprüft, dass die Steuereinheit (62) elektrisch mit der Datenverwaltungseinheit (18) verbunden ist, und in dem Fall, in dem die Verbindung zwischen der Steuereinheit (62) und der Datenverwaltungseinheit (18) unterbrochen ist, in einen Notbetriebsmodus überzugehen.

9. Steuerverfahren nach Anspruch 8, **dadurch gekennzeichnet, dass** im Notbetriebsmodus der Aktor (60) ausgelöst wird.

10. Steuerverfahren nach Anspruch 8, **dadurch gekennzeichnet, dass** im Notbetriebsmodus ein Benutzer über die Unterbrechung der Verbindung zwischen der Steuereinheit (62) und der Datenverwaltungseinheit (18) mit Hilfe einer Kontrollleuchte unterrichtet wird, die vorzugsweise auf der Steuereinheit angeordnet ist.

11. Steuerverfahren nach Anspruch 8, **dadurch gekennzeichnet, dass** im Notbetriebsmodus eine Nachricht, die eine für den Zustand der Verbindung zwischen der Steuereinheit (62) und der Datenverwaltungseinheit (18) repräsentative Information enthält, mit Hilfe eines Senders der Steuereinheit (62) vorzugsweise an eine ausgelagerte oder nicht ausgelagerte Anzeigevorrichtung des Aktors (60) gesendet wird.

## Claims

1. Process for manufacturing a circuit breaker (100) comprising manufacturing a measuring sensor (10) for said circuit breaker (100), said process for manufacturing the measuring sensor (10) comprising the following successive steps:
A step of providing a current-measuring unit (12) comprising a torus able to be passed through by a primary conductor (R, S, T, N) and comprising a first conductor wound around the torus, a current transformer (14) able to be passed through by the primary conductor (R, S, T, N), a voltage-measuring unit (16) able to be connected to the primary conductor (R, S, T, N) in order to measure a potential appearing in the primary conductor (R, S, T, N), and a data-managing unit (18) comprising a nonvolatile memory (20);
A step of characterizing the measuring sensor (10) consisting in determining the phase shift of an electrical signal induced in the first conductor with respect to an electrical signal induced in the primary conductor (R, S, T, N) and of an electrical signal induced in the voltage-measuring unit (16) with respect to an electrical signal induced in the primary conductor (R, S, T, N), in determining a current gain of the electrical signal induced in the first conductor with respect to the electrical signal induced in the primary conductor (R, S, T, N) and in determining a voltage gain of the electrical signal induced in the voltage-measuring unit (16) with respect to the electrical signal induced in the primary conductor (R, S, T, N);
A step of parameterizing the data-managing unit (18), consisting in recording a datum representative of the phase shift, a datum representative of the current gain and a datum representative of the voltage gain determined in the step of characterizing the measuring sensor (10), in the nonvolatile memory (20),
said process for manufacturing a circuit breaker (100) being **characterized in that** it further comprises the following successive steps:
A step of providing an actuator (60) comprising a controlling unit (62);
A step of pairing the data-managing unit (18) with the controlling unit (62), consisting in electrically connecting the data-managing unit (18) to the controlling unit (62) so that the controlling unit (62) is able to retrieve the datum representative of the phase shift and/or the datum representative of the current gain and/or the datum representative of the voltage gain of the nonvolatile memory (20) of the data-managing unit (18) .

2. Process for manufacturing a circuit breaker (100) according to Claim 1, **characterized in that**, in the step of characterizing the measuring sensor, the phase shift is determined by passing the primary conductor (R, S, T, N) through the torus, by applying an AC current of known phase shift to said primary conductor (R, S, T, N), by measuring the total phase shift of the current induced in the first conductor and by subtracting the known phase shift from the measured total phase shift.

3. Process for manufacturing a circuit breaker (100) according to either one of Claims 1 and 2, **characterized in that**, in the step of characterizing the measuring sensor, the current gain is determined by applying a current of known magnitude to the primary conductor (R, S, T, N), by measuring the magnitude of the current induced in the primary conductor (R, S, T, N) and by dividing the magnitude of the current induced in the primary conductor (R, S, T, N) by the magnitude of the current of known magnitude, and **in that**, in the step of characterizing the measuring sensor, the voltage gain is determined by applying a known voltage to the primary conductor (R, S, T, N), by measuring the voltage induced in the voltage-measuring unit (16) and by dividing the voltage induced in the voltage-measuring unit (16) by the voltage of the current of known voltage.

4. Circuit breaker comprising a measuring sensor (10), said measuring sensor (10) comprising at least one current-measuring unit (12) comprising a torus able to be passed through by a primary conductor (R, S, T, N) , and a first conductor wound around the torus, a current transformer (14) able to be passed through by the primary conductor (R, S, T, N) and a voltage-measuring unit (16) able to be connected to the primary conductor (R, S, T, N) in order to measure a potential appearing in the primary conductor (R, S, T, N), said circuit breaker further comprising an actuator (60) comprising a controlling unit (62), **characterized in that** said measuring sensor (10) further comprises a data-managing unit (18) comprising a nonvolatile memory (20), **in that** the data-managing unit (18) is electrically connected to the controlling unit (62) so that the controlling unit (62) is able to retrieve the datum representative of the phase shift and/or the datum representative of the current gain and/or the datum representative of the voltage gain of the nonvolatile memory (20) of the data-managing unit (18) and **in that** the measuring unit is manufactured using the process according to any one of Claims 1 to 3.

5. Circuit breaker according to Claim 4, **characterized in that** the controlling unit (62) comprises at least one microcontroller (66) and at least one memory (64), preferably at least one nonvolatile memory, the microcontroller (66) preferably being able to save the datum representative of the phase shift and/or the datum representative of the current gain and/or the datum representative of the voltage gain in the memory (64) of the controlling unit (62).

6. Circuit breaker according to Claim 4 or Claim 5, **characterized in that** the torus and the first conductor wound around the torus form a Rogowski torus.

7. Method for controlling a circuit breaker (100) according to any one of Claims 4 to 6, **characterized in that** it comprises the following successive steps:
A step of retrieving the datum representative of the phase shift and/or the datum representative of the current gain and/or the datum representative of the voltage gain from the nonvolatile memory (20) of the data-managing unit (18) with the microcontroller (66) of the controlling unit (62);
A step of saving the datum representative of the phase shift and/or the datum representative of the current gain and/or the datum representative of the voltage gain in the memory (64) of the controlling unit (62) ;
A step of calibrating the controlling unit (62) consisting in determining at least a first triggering threshold depending on the datum representative of the phase shift and/or the datum representative of the current gain and/or the datum representative of the voltage gain; and
An operating step in which the actuator (60) is triggered when the current measured by the current-measuring unit (12) is higher than the first triggering threshold.

8. Controlling method according to Claim 7, **characterized in that**, in the operating step, the controlling unit (62) checks at regular time intervals and non-stop that the controlling unit (62) is electrically connected to the data-managing unit (18) and, in the case where the connection between the controlling unit (62) and the data-managing unit (18) is interrupted, a standby operating mode is passed to.

9. Controlling method according to Claim 8, **characterized in that**, in the standby operating mode, the actuator (60) is triggered.

10. Controlling method according to Claim 8, **characterized in that**, in the standby operating mode, a user is warned of the interruption of the connection between the controlling unit (62) and the data-managing unit (18) using an indicator light, which is preferably arranged on the controlling unit.

11. Controlling method according to Claim 8, **characterized in that**, in the standby operating mode, a message containing information representative of the state of the connection between the controlling unit (62) and the data-managing unit (18) is sent using a sender of the controlling unit (62), preferably to a displaying device that may optionally be remote from the actuator (60) .
